# EUROPEAN PATENT APPLICATION

(11) **EP 3 576 297 A1**
(43) Date of publication of application: **04.12.2019**
(21) Application number: 18175365.8
(22) Date of filing: 31.05.2018
(51) Int. Cl.: H02P 29/024, G01R 31/02

(54) **METHOD FOR LOCALIZING SHORT CIRCUITS IN A SUPPLY CIRCUIT OF A PMM MOTOR**

(71) Applicant: ALSTOM FERROVIARIA S.P.A., 12038 Savigliano (Cuneo) (IT)
(72) Inventor: BARLINI, Davide, 65320 Bordères-sur-l'Échez (FR)
(74) Representative: Lavoix

(57) **Abstract**

This method is for localizing short circuits in a supply circuit (1) of a PMM motor (2), said supply circuit (2) comprising a DC voltage source (4), placed between a first branch (4a) and a second branch (4b), and parallel branches (10b, 10c, 10d, 10e) placed in parallel between the positive branch (4a) and the negative branch (4b). On a first parallel branch (10b) there is a capacitor (14). On second (10c), third (10d) and fourth (10e) parallel branches, there are respective couple of switches placed in series, in particular a first switch (S1) and a second switch (S2) on the second parallel branch (10c), a third switch (S3) and a fourth switch (S4) on the third parallel branch (10d), a fifth switch (S5) and a sixth switch (S6) on the fourth parallel branch (10e). Three branches (18a, 18b, 18c) connect on one side respective phases (18a', 18b', 18c') of the PMM motor (2) with, on the opposite side, the third, fourth and fifth parallel branches (10c, 10d, 10e), between the respective couples of switches (S1, S2; S3, S4; S5, S6). The method comprises the steps of a) charging (100) the capacitor (14) through the DC voltage source (4); b) transferring (200) energy from the capacitor (14) to the PMM motor (2) through the first switch (S1) and the fourth switch (S4) in a first period and returning (202) energy to the capacitor (14) through freewheeling diodes (D2, D3) respectively associated to the second switch (S2) and to the third switch (S3) in a following second period; c) measuring (204) a first voltage difference (ΔVFD2-D3) between a predetermined initial voltage value (VO) and a first final voltage value (Vth1) on the capacitor (14) at the end of the second phase period; and d) detecting a short circuit in function of the comparison of the first voltage difference (ΔVFD2-D3) with a first predetermined threshold voltage value (Vth').

## Description

The present invention concerns a method for localizing short circuits in a supply circuit of a PMM motor.

It is common in AC electric motor drive systems to employ power inverter systems to furnish electric power from a DC source to an AC motor. These inverter systems are of various types, but they often comprise gate turn-off thyristors (GTO), Insulated Gate Bipolar Transistor (IGBT) in a bridge arrangement. The GTOs or IGBTs in the bridge are selectively gated to control the electrical power supplied to the motor, by converting DC power from the DC source into AC power which drives the motor. Typically, two GTOs or IGBTs are connected in a series arrangement between relatively positive and relatively negative busses of the DC source. A common inverter of this type is a three-phase inverter having three legs connected in parallel between the positive and negative DC source busses. The GTOs or IGBTs of each of the legs are rendered conductive in a predetermined order or sequence in order to control the electrical power delivered from the DC busses to the AC motor.

Recently, in railway vehicles, Permanent Magnet Motors (PMMs) are often used as AC motor instead of Asynchronous Motors (AMs).

The main advantages of the PMM motor against the AM motor can be briefly summarized in higher efficiency and mass and volume reduction (at a same power rate).

Due to the fact that in a PMM motor the rotor magnetic flux is directly produced by a permanent magnet and not induced by an inverter current, Joule losses into the rotor are not produced.

Based on this principle, it has been noted that in such machines voltage into the motor terminals is always generated, proportionally to the rotor speed.

This could be a problem, especially once failure to the system occurs. For example, in case of short circuit in the circuit supplying the PMM motor, the connected PMM motor continues to operate supplying the short circuit itself, with risk to have a fire in the system, as explained in detail here below.

In order to prevent this situation, a three-phases switch is always connected upstream the PMM motor, in the supply circuit of the PMM motor, as disclosed for example in US 6078173.

With this device it is possible to get a barrier in case a short circuit occurs upstream the three-phase switch, by opening the three-phases switch, thus stopping the supply to the PMM motor. However, it is not possible to have any protection in case the short circuit occurs downstream the three-phase switch, between the three-phase switch and the PMM motor itself, as detailed here below.

During train operation all the short circuit types which can occur upstream the three-phase switch can therefore be well managed by simply opening the three-phase switch and disconnecting the corresponding traction system. In this case the train on which the PMM motor is installed falls down in a degraded mode, i.e. runs with one traction system less, without any safety issue.

In some traction architecture the consequence of this action is to lose all the motors connected to a common part (traction system) of a traction chain of the train. Therefore, it would be desirable to correctly identify which kind of short circuit has occurred and where it is located, in order to know which action has to be performed to guaranty safety without losing unnecessary performances.

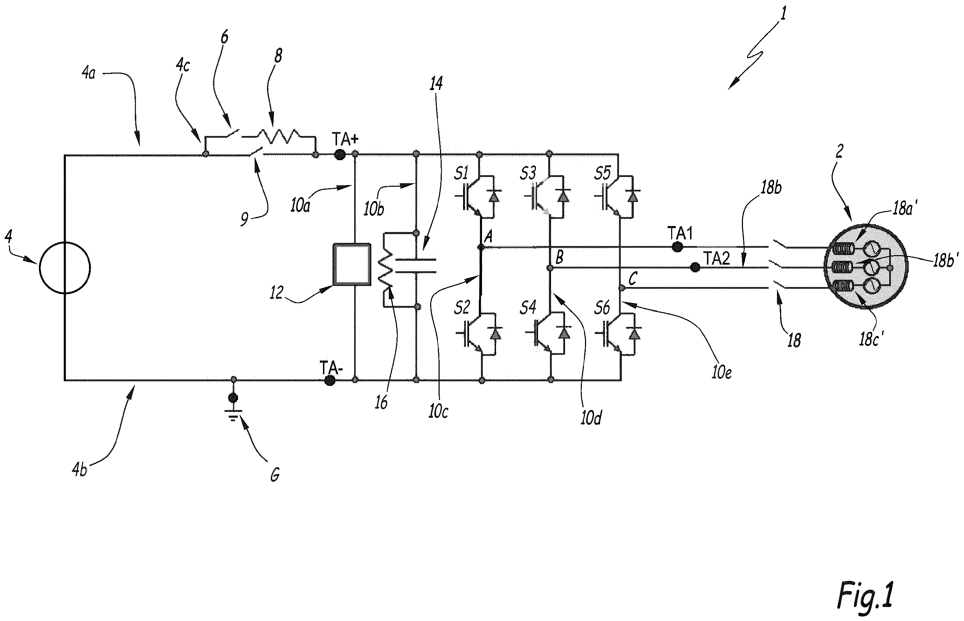

Figure 1 shows a circuit 1 for supplying a PMM motor 2 wherein short circuits are detected according to the prior art. The circuit 1 comprises, starting from a left side of the figure 1, a DC voltage source 4 placed between a positive branch 4a and a grounded branch 4b. A first switch 6 and a pre-charging resistance 8 are placed on an auxiliary branch 4c in parallel with respect to the positive branch 4a. An auxiliary switch 9 is placed on the positive branch 4a, in parallel to the auxiliary-branch 4c.

Five parallel branches 10a, 10b, 10c, 10d and 10e are placed in parallel between the positive branch 4a and the grounded branch 4b.

On the first parallel branch 10b there is a filter element comprising a capacitor 14 and a discharging resistance 16. The capacitor 14 is usually pre-charged through the pre-charging resistance 8 (i.e., by applying a voltage on it through the DV voltage source 4; thus obtaining a current flowing into the pre-charging resistance 8).

On the second, third and fourth parallel branches 10c, 10d and 10e there are respective couple of switches placed in series, in particular switches S1 and S2 on the second parallel branch 10c, switches S3 and S4 on the third parallel branch 10d and switches S5 and S6 on the fourth parallel branch 10e.

On the fifth parallel branch 10a there is a voltage sensor 12.

A three-phase switch 18, placed on the side opposite to the one where there is the DC voltage source 4, comprises, in a manner per se known, three branches 18a, 18b and 18c connecting, on one side, respective phases 18a', 18b', 18c' of the PMM motor 2 with, on the opposite side, the second, third and fourth parallel branches 10c, 10d and 10e, between the respective couples of switches S1-S6.

According to the prior art, one way for identifying and localizing short circuits is through the use of current sensors.

The first way to detect short circuits versus ground is achieved, in a manner per se known, by using differential current sensors TA+ and TA- which detect a short circuit once an input current on the positive branch 4a is higher than a corresponding output current on the branch 4b.

Of course if the short circuit occurs between two phases 18a', 18b', 18c' for example, this configuration doesn't intercept the short circuit. In this case, current sensor TA1 and TA2, placed respectively on two of the branches 18a, 18b, 18c of the three-phase switch 18, can be used to measure the current flowing on the respective branch 18a, 18b, 18c, thus identifying huge current intercepting if a short circuit is present on said branch 18a, 18b, 18c.

In the case of short circuit versus ground happens, the differential current sensors TA+ and TA- indicate, in general, the presence of such short circuit in the circuit 1, but it cannot be exactly determined, therefore, as a safety measure, it is necessary to fully disconnect the PMM motor 2 and traction system.

With reference to the above, if the short circuit is located upstream the three-phase switch 18, the disconnection of the switch 6, in conjunction with switch 9 and the three-phase switch 18 permits to isolate the short circuit by sources energy, thus achieving the safety requirements required in railway transportation, just operating with one motor less but without limiting the train speed.

If, on the contrary, the short circuit is downstream the three-phase switch 18, the safety analysis is more complicated.

If for example a short circuit occurs on the first phase 18a', the disconnection of the traction system, as previously indicated, does not permit to achieve safety requirement alone. In such case the short circuit is always supplied by the motor 2 which is acting as power generator once the train is running. As consequence, to achieve safety requirement, the train must operate at reduced speed too, having a huge impact on service exploitation. If it is not possible to identify the location of short circuit the train must to consider the worst scenario: isolate the traction system and operate at reduced safety speed

In view of the above, it would be important to correctly identify which kind of short circuit has occurred and its localization, in order to know how to cope with it without limiting train speed if not necessary.

There is therefore the need to have an innovative method for localizing short circuits in a supply circuit of a PMM motor which is capable of identifying short circuits occurring between the phases of the PMM motor 2 without requiring supplying of the circuit itself during the diagnostic phase, and without requiring additional devices on the circuit, thus overcoming the limitations of the prior art solutions.

These and other objects are achieved by a method for localizing short circuits in a supply circuit of a PMM motor having the characteristics defined in claim 1.

Preferred embodiments of the invention are the subject matter of the dependent claims, whose content is to be understood as forming an integral part of the present description.

Further characteristics and advantages of the present invention will become apparent from the following description, provided merely by way of non-limiting example, with reference to the enclosed drawings, in which:
- Figure 1 shows a circuit for supplying a PMM motor according to the prior art;
- Figure 2 shows a block diagram of the steps of a first diagnostic procedure of the method according to the present invention;
- Figure 3 shows a closing/opening sequence applied to the switches S1-S6;
- Figure 4 shows a graph of the voltage measured by the voltage sensor;
- Figure 5 shows a block diagram of the steps of a second diagnostic procedure of the method according to the present invention;
- Figure 6 shows the circuit of figure 1 wherein energy is transferred from a capacitor of the supplying circuit to the inductances L of the PMM motor;
- Figure 7 shows the closing/opening sequence of switches S1 and S4 and the voltage Vc on the capacitor with respect to time during a discharging phase of the capacitor;
- Figure 8 shows the circuit of figure 1 wherein energy is transferred back from the inductances of the PMM motor to the capacitor;
- Figure 9 shows the closing/opening sequence of switches S1 and S4 and the voltage Vc on the capacitor 14 with respect to time during a re-charging phase of the capacitor;
- Figure 10 which represents the closing/opening sequence of switches S1 and S4, and S2 and S3 from the beginning to the end of the second diagnostic procedure;
- Figure 11 shows the circuit of figure 1 wherein energy is transferred from the capacitor to the inductances L of the PMM motor; and
- Figure 12 shows the circuit of figure 1 wherein energy is transferred back from the inductances of the PMM motor to the capacitor.

Briefly, the method according to the present invention uses the voltage sensor 12 for localizing short circuits in the supply circuit of the PMM motor 2 with the assumption the power inverter is still properly working.

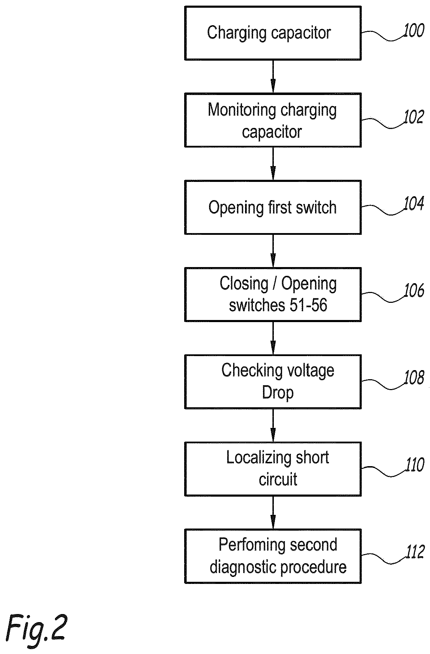

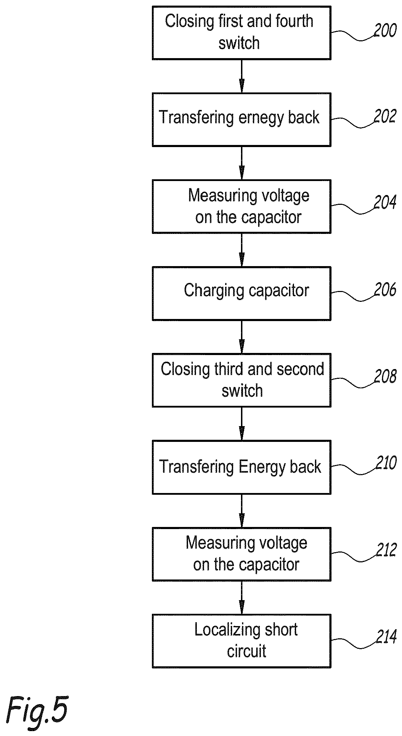

In the following of the description, a method for localizing short circuits in a supply circuit of a PMM according to the present invention will be disclosed, with reference to figures 2 and 5 which show respective block diagrams of a first diagnostic procedure and a second diagnostic procedure of the method according to the present invention.

When a short circuit occurs in the supply circuit of the PMM motor 2, an alert is sent, in a manner per se known, to a control unit of a train wherein the PMM motor 2 is hosted, for example by using the differential current sensors TA+ and TA- or huge current detection by TA1 or/and TA2.

At this point, the train is stopped and/or the corresponding traction system connected to PMM motor 2 is excluded, i.e. the switch 6, 9 and the three-phase switch 18 are opened on all the three braches 18a, 18b, 18c, before starting the train again in degraded mode.

During the stop/exclusion phase a first diagnostic procedure to detect the nature of the short circuit is performed, in an automatic manner or on demand by a driver of the train.

The following steps of the first diagnostic procedure are applied to localize a short circuit, as disclosed with reference to figure 2.

In a first step 100 of the method according to the present invention, the capacitor 14 is charged through the first switch 6 and the pre-charging resistance 8 as above disclosed. During this phase the current is always limited by pre-charge resistance 8.

In a further step 102 it is monitored if the capacitor 14 has been charged by means of voltage sensor 12.

If the DC voltage source 4 hasn't charged the capacitor 14, it means that there is a short circuit bypassing the capacitor 14, and the diagnostic phase is terminated because the short circuit has been localized.

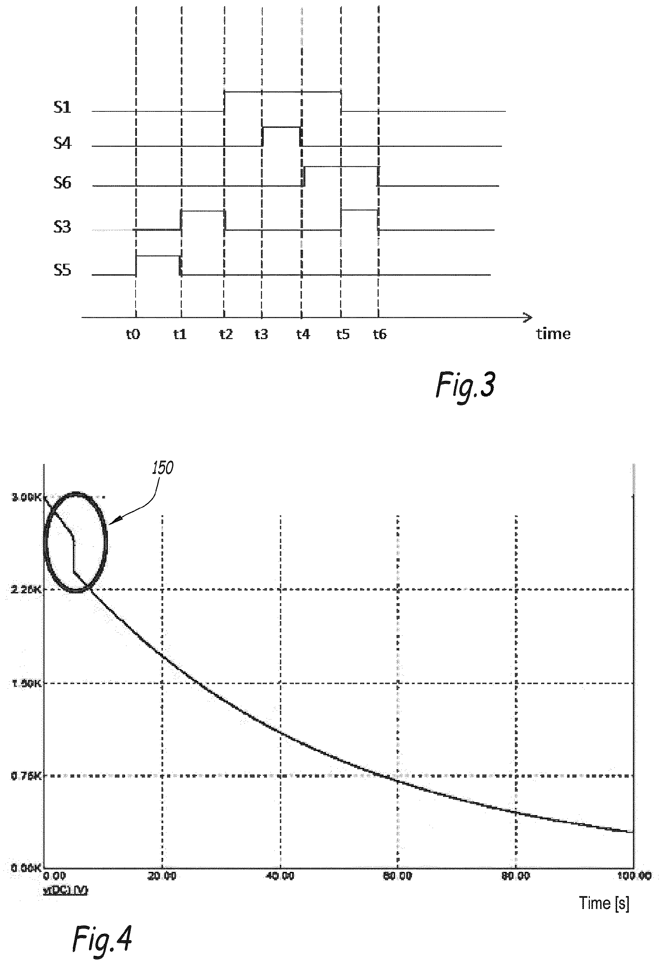

If the DC voltage source 4 has charged the capacitor 14, in a step 104, the first switch 6 is opened thus isolating the capacitor 14 from the DC voltage source and leaving the capacitor 14 fully charged. At this point, in a step 106, the closing/opening sequence shown in Figure 3 is applied to the switches S1-S6 so as to detect a voltage drop, as herein below explained in detail.

In particular, between an initial time t0 and a first time t1, the fifth switch S5 is closed to detect if there is a short circuit between the third branch 18c and a ground G of the circuit 1, then, at the first time t1, the fifth switch S5 is opened; between the first time t1 and a second time t2, the third switch S3 is closed to detect if there is a short circuit between the second branch 18b and ground G, then, at the second time t2, the third switch S3 is opened; between the second time t2 and a third time t3, the first switch S1 is closed to detect if there is a short circuit between the first branch 18a and the ground G. At this point if any voltage drop of the capacitor has been detected, the short circuit doesn't involve electrical phase leakage versus ground and the sequence pattern of Figure 3 continues to identify if short circuit is between electrical phases. The first switch S1 remains closed; between the third time t3 and a fourth time t4, the fourth switch S4 is closed while the first switch S1 remains closed, to detect if there is a short circuit between the first branch 18a and the second branch 18b, then at the fourth time t4, the fourth switch S4 is opened; between the fourth time t4 and a fifth time t5, the sixth switch S6 is closed while the first switch S1 remains closed, to detect if there is a short circuit between the first branch 18a and the third branch 18c, then, at the fifth time t5, the first switch S1 is opened; between the fifth time t5 and a sixth time t6, the third switch S3 is closed while the sixth switch S6 remains closed, to detect if there is a short circuit between the second branch 18b and the third branch 18c, then, at the sixth time t6, both the third switch S3 and the sixth switch S6 are opened.

Due to the presence of the discharging resistance 16, the voltage on the capacitor 14, which is monitored by the voltage sensor 12, start decreasing in a manner per se known, with a constant time function of a resistance R and capacitance C value of the capacitor 14 and the discharging resistance 16.

This voltage decreasing is negligible with respect to a short circuit voltage drop on the capacitor 14 caused by a short circuit on the switches S1-S6.

Figure 4 shows a graph of the voltage measured by the voltage sensor 12 as a function of time, wherein a simulated sudden voltage drop 150, representative of a short circuit voltage drop on the capacitor 14 caused by a short circuit on any of the switches S1-S6, is compared with a voltage decreasing for discharging into the discharging resistance 16.

It is worth to point out that the eventual short circuit is energized just with the amount of energy stored into the capacitor 14 and not by the whole voltage applied by the DC voltage source 4.

In an alternative embodiment of the invention, the capacitor 14 is charged with only a predetermined charge value lower that its maximum one so that the above disclosed steps can be performed also with a low voltage of the circuit 1.

Returning now to figure 2, at this point, at step 108, the voltage measure measured on the capacitor 14 are gathered and it is checked if a short circuit voltage drop has occurred on the capacitor 14. In positive case, at step 110 the kind of short circuit is identified by correlating the sequence of closing/opening phases of the switches S1-S6 above disclosed with the short circuit voltage drop detected by the voltage sensor 12 and the short circuit is also localized upstream the three-phase switch 18.

In negative case, it means that the short circuit is located downstream the three-phase switch 18, i.e. between the three-phase switch 18 and the PMM motor 2, therefore a second diagnostic procedure has to be performed at step 112, whose steps will be disclosed in the following with reference to figure 5.

Usually this information is enough to decide if the train can continue to operate in a degraded mode or not without fire risk, thus allowing deciding which measure undertake to fulfill the safety requirements.

The second diagnostic procedure is applied in case of short circuit occurring downstream the three-phase switch 18, to know the nature of the short circuit.

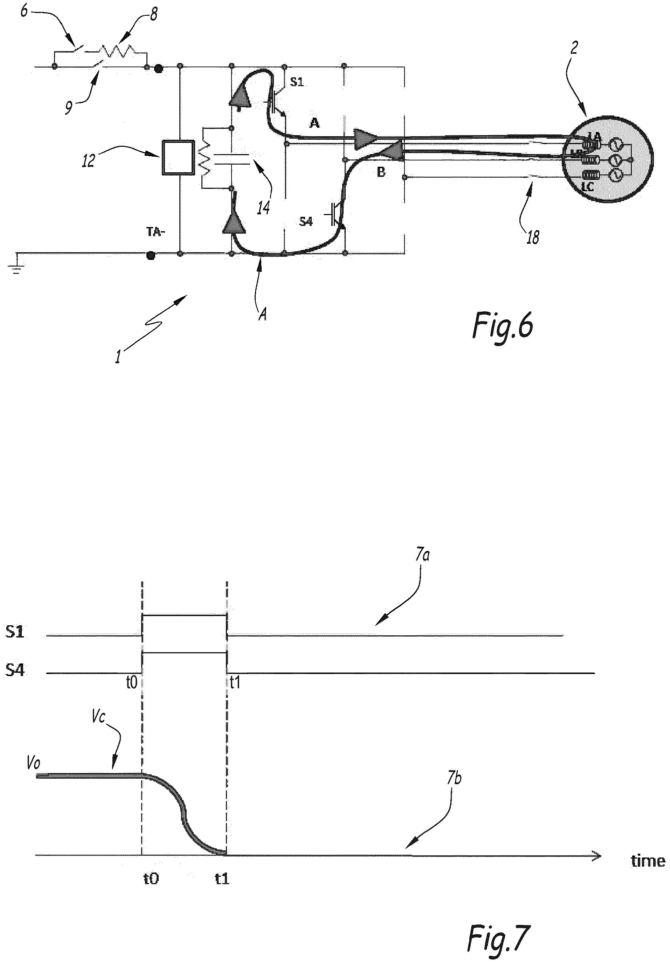

Figure 6 shows the testing of the first phases 18a and the second phase 18b starting from the following initial condition:
- first switch 6 and auxiliary switch 9 opened;
- capacitor 14 charged at an initial voltage value V0 (a predetermined voltage level, not necessary the level of the voltage provided by the DC voltage source 4);
- three-phase switch 18 closed.

The steps here below disclosed allows to detect a possible short circuit between the first phase 18a' and ground, the second phase 18b' and ground, and the first phase 18a' and the second phase 18b', downstream the three-phase switch 18.

With reference to figure 6, in a first phase 200 of the second diagnostic procedure, the first switch S1 and the fourth switch S4 are closed (switched on) at an initial time t0 so that energy is transferred from the capacitor 14 to the first phase 18a' and the second phase 18b', in particular to inductances LA and LB of the PMM motor 2, through a current represented by an arrow A on the circuit 1 in figure 6.

Figure 7 shows in a top section 7a the closing/opening sequence of switches S1 and S4 in a discharging phase of the capacitor14. In a bottom section 7b of figure 7 it is depicted the voltage Vc on the capacitor 14 with respect to time, said capacitor voltage Vc decreasing while current is flowing towards the PMM motor 2 between the first phase 18a' and the second phase 18b'. The voltage decrease ΔVc represents the voltage drop for the first phase 18a'-second phase 18b' charging.

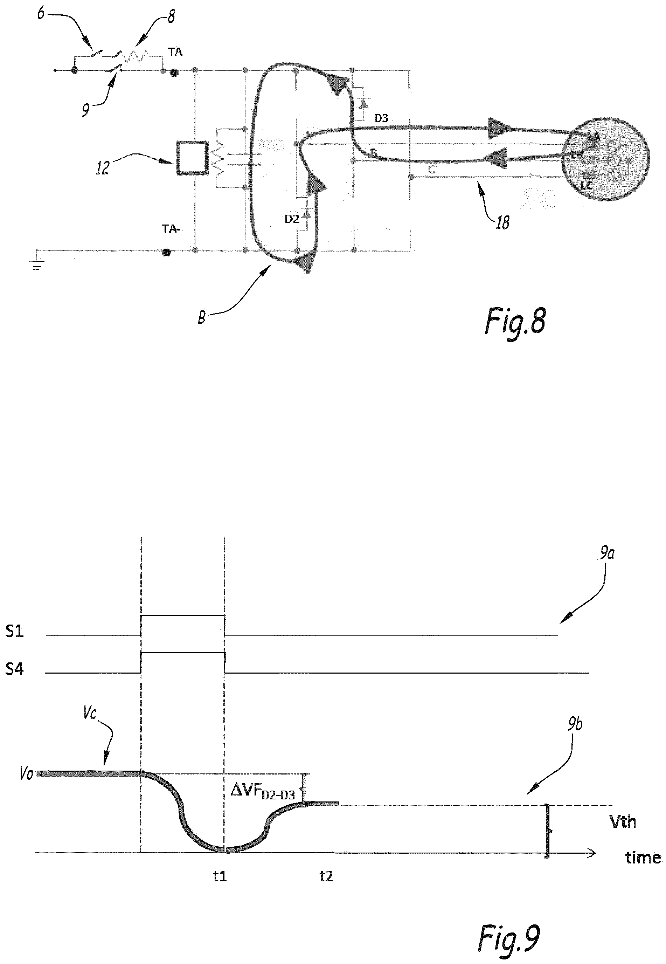

After a first time t1, in a further phase 202, energy is transferred back from LA and LB of the PMM motor 2 through the first phase 18a' and second phase 18b' of the PMM motor 2 to the capacitor 14 through freewheeling diodes D2 and D3 respectively associated, in a manner per se known, with the second and third switch S2 and S3, as represented by an arrow B on the circuit 1 in Figure 8.

Then, in a further step 204 at the end of the above disclosed sequence, the voltage on the capacitor 14 is measured through the voltage sensor 12.

Figure 9 shows in a top section 9a the closing/opening sequence of switches S1 and S4 in a re-charging phase of the capacitor. In a bottom section 9b of figure 9 it is depicted the voltage Vc on the capacitor 14 with respect to time. Said capacitor voltage Vc increases, starting from the first time t1 and up to a second time instant t2, while current is flowing back towards the capacitor 14.

A first voltage difference ΔVF_{D2-D3} between the initial voltage value V0 and a first final voltage value Vth1 at t2 measured on the capacitor 14 represents a measure of the dissipated energy due to stray resistance on cabling, capacitor 14, PMM motor 2 and three-phase switch 18, and switch and conduction losses on switches S1 and S4 and freewheeling diodes D2 and D3.

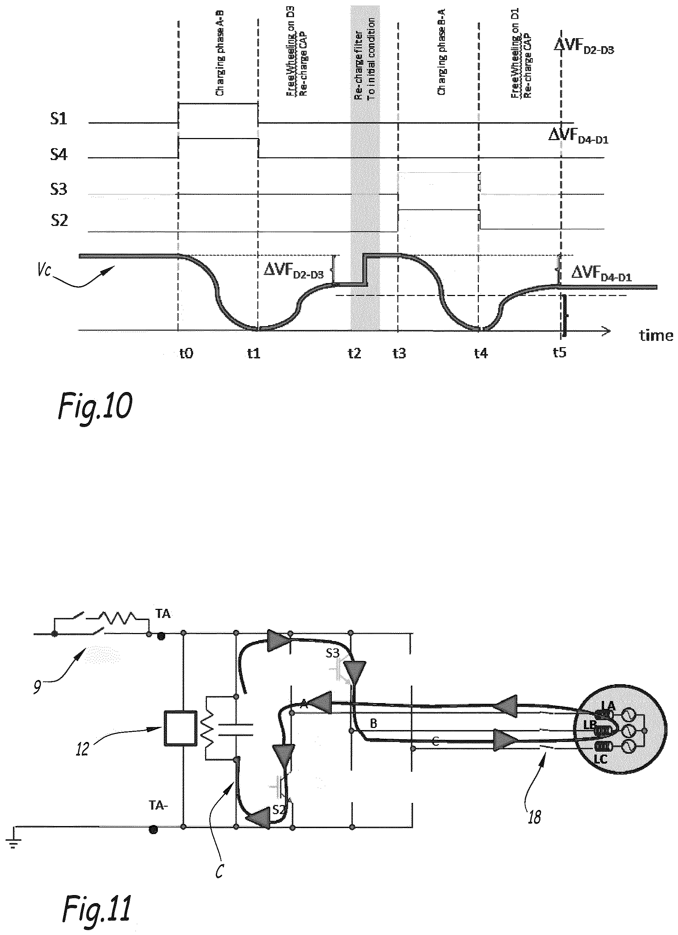

At this point, at step 206 and with reference to figure 10 which represents the closing/opening sequence of switches S1 and S4 above disclosed, and S2 and S3 here below detailed, and the correlated voltage Vc on the capacitor 14, from the beginning to the end of the second diagnostic procedure, the capacitor 14 is charged again at the initial voltage value V0 by means of switch 6 and pre-charge resistance 8 and the same phases 18b' and 18a' are re-tested in reversing way.

In a further step 208, from the third time instant t3 to a fourth time instant t4, the third switch S3 and the second switch S2 are closed, so that energy is transferred from capacitor 14 to the first and second phase of the PMM motor 2, in particular to inductances LB and LA, of the PMM motor, 2 through a current represented by an arrow C on the circuit 1 in figure 11.

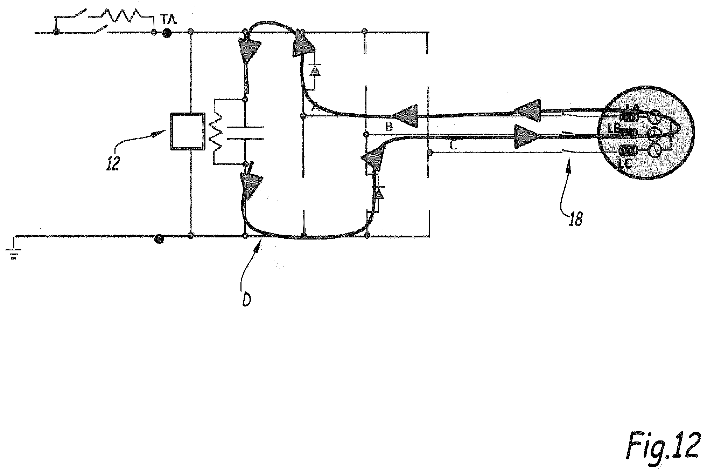

From the fourth time t4 to a fifth time t5, in a further phase 210, energy is transferred back from LA and LB of the PMM motor 2 through the first phase 18a' and 18b' of the PMM motor 2 to the capacitor 14, through freewheeling diodes D1 and D4 respectively associated, in a manner per se known, with the first and fourth switch S1 and S4, as represented by an arrow D on the circuit 1 in Figure 12.

Then, in a further step 212, the voltage on the capacitor 14 is measured through the voltage sensor 12.

With reference to figure 10, a second voltage difference ΔVF_{D4-D1} between the initial voltage value V0 and a second final voltage value Vth2 at t5 represents a measure of the dissipated energy due to stray resistance on cabling, capacitor 14, PMM motor 2 and three-phase switch 18, and switch and conduction losses on switches S2 and S3 and freewheeling diodes D1 and D4.

At this point, at step 214 the short circuit detected for the first phase 18a' and the second phase 18b' is localized based on the following rules.

If the first voltage difference ΔVF_{D2-D3} is higher than a first predetermined threshold voltage value, i.e. the final voltage value Vth1 at t2 is below a first tension threshold Vth', or the second voltage difference ΔVF_{D4-D1} is higher than a second predetermined threshold voltage value, i.e. the final voltage Vth2 value at t5 is below a second tension threshold Vth", a short circuit is detected, otherwise, it means that the short circuit is located between the second phase 18b' and the third phase 18c' or between the third phase 18c' and the first phase 18a' or between the third phase and the ground.

Advantageously, the first Vth' and the second Vth" predetermined threshold are the same.

In case a short-circuit is detected following the above-mentioned rules:
- If the first voltage difference ΔVF_{D2-D3} is greater than the second voltage difference ΔVF_{D4-D1}, there is a short circuit between the first phase 18a' and ground G.
- If the first voltage difference ΔF_{D2-D3} is lesser than the second voltage difference ΔVF_{D4-D1}, there is a short circuit between the second phase 18b' and ground G.
- If the first voltage difference ΔVF_{D2-D3} is equal to the second voltage difference ΔVF_{D4-D1}, there is a short circuit between the first phase 18a' and the second phase18b'.

In case no short circuit has been detected, it is necessary to apply the steps 200-214 in similar way also for the second phase 18b' and the third phase 18c', and also for the third phase 18c' and the first phase 18a'.

In particular, for testing the second phase 18b' and the third phase 18c' the switches S3 and S6 are closed, while for testing third phase 18c' and the first phase 18a' the switches S4 and S5 are closed.

The main advantages of the method according to the present invention are that the short circuit is not supplied when carrying out the diagnostic phases, no new devices have to be added to the circuit 1 and the three-phase switch 18 does not suffer damages during short-circuits.

Clearly, the principle of the invention remaining the same, the embodiments and the details of production can be varied considerably from what has been described and illustrated purely by way of non-limiting example, without departing from the scope of protection of the present invention as defined by the attached claims.

## Claims

1. Method for localizing short circuits in a supply circuit (1) of a PMM motor (2), said supply circuit (1) comprising:
- a DC voltage source (4) placed between a first branch (4a) and a second branch (4b);
- parallel branches (10b, 10c, 10d, 10e) placed in parallel between the positive branch (4a) and the negative branch (4b) wherein:
- on a first parallel branch (10b) there is a capacitor (14);
- on second (10c), third(10d) and fourth (10e) parallel branches there are respective couple of switches placed in series, in particular a first switch (S1) and a second switch (S2) on the second parallel branch (10c), a third switch (S3) and a fourth switch (S4) on the third parallel branch (10d), a fifth switch (S5) and a sixth switch (S6) on the fourth parallel branch (10e);
- three branches (18a, 18b, 18c) connecting on one side respective phases (18a', 18b', 18c') of the PMM motor (2) with, on the opposite side, the second, third and fourth parallel branches (10c, 10d, 10e), between the respective couples of switches (S1, S2; S3, S4; S5, S6);
the method comprising the steps of:
a) charging (100) the capacitor (14) through the DC voltage source (4);
b) transferring (200) energy from the capacitor (14) to the PMM motor (2) through the first switch (S1) and the fourth switch (S4) in a first period and returning (202) energy to the capacitor (14) through freewheeling diodes (D2, D3) respectively associated to the second switch (S2) and to the third switch (S3) in a following second period;
c) measuring (204) a first voltage difference (ΔVF_{D2-D3}) between a predetermined initial voltage value (V0) and a first final voltage value (Vth1) on the capacitor (14) at the end of the second period;
d) detecting a short circuit in function of the comparison of the first voltage difference (ΔVFD_{2-D3}) with a first predetermined threshold voltage value (Vth').

2. The method of claim 1, further comprising:
e) repeating steps b) and c) by closing the third switch (S3) and the second switch (S2) in a third period and transferring the energy back through freewheeling diodes (D1, D4) respectively associated to the first switch (S1) and to the fourth switch (S4) in a following fourth period, thus obtaining a second voltage difference (Δ_{VFD1-D4}) between the predetermined initial voltage value (V0) and a second final voltage value (Vth2) at the end of the fourth period;
f) detecting a short circuit in function of the comparison of the second voltage difference (Δ_{VFD1-D4}) with a second predetermined threshold voltage value (Vth").

3. The method of claim 1 or 2, wherein the supply circuit comprises a voltage sensor adapted for measuring the voltage on the capacitor and the method comprises:
g) applying (106) a predetermined closing/opening sequence to the switches (S1-S6);
h) checking (108), through the voltage sensor (12), if a short circuit voltage drop has occurred on the capacitor (14) and in positive case, localizing (110) the short circuit by correlating the closing/opening sequence of the switches (S1-S6) with said short circuit voltage drop.

4. The method according to any of the preceding claims, wherein a three-phase switch (18), is placed on the three branches (18a, 18b, 18c).

5. The method according to any of the preceding claims, wherein the parallel branches comprise a fifth parallel branch (10a) comprising a voltage sensor (12).

6. The method of claim 2, further comprising:
- i) in case a short circuit is detected in step d) or f), localizing the short circuit by comparing the values of the first voltage difference (ΔVF_{D2-D3}) and second voltage difference (ΔVF_{D1-D4});

7. The method of claim 2, further comprising:
in case the short circuit is not detected in d) or f), repeating the steps b) and c) for the second phase (18b') and the third phase (18c') and for the third phase (18c') and the first phase (18a') using the corresponding switches (S3, S6; S4, S5).

8. The method of claim 1, further comprising:
- if the capacitor (14) does not charge, localize a short circuit bypassing the capacitor (14)

9. The method according to claim 1, wherein the step of transferring (200) energy from the capacitor (14) to the PMM motor (2) includes the steps of:
- transferring (200) energy from the capacitor (14) to the first phase (18a') of the PMM motor (2) and then to the second phase (18b') by means of a current flowing through the first switch (S1) and the fourth switch (S4);
- transferring back (202) energy from the PMM motor (2) to the capacitor (14) by means of a current flowing through the freewheeling diodes (D2, D3) respectively associated to the second switch (S2) and to the third switch (S3);

10. The method according to claim 2, wherein the step of repeating steps b) and c) by closing the third switch (S3) and the second switch (S2) includes the steps of:
- charging (206) again the capacitor (14) to the predetermined initial voltage value (V0);
- repeating steps b) and c) by transferring (200) energy from the capacitor (14) to the second phase (18b') of the PMM motor (2) and then to the first phase (18a') by means of a current flowing through the third switch (S3) and the second switch (S2) closing the third switch (S3) and the second switch (S2) and by transferring the energy back from the PMM motor (2) to the capacitor (14) through the freewheeling diodes (D1, D4) respectively associated to the first switch (S1) and to the fourth switch (S4).

11. The method according to claim 6, wherein the step of localizing the short circuit by comparing the values of the first voltage difference (ΔVF_{D2-D3}) and second voltage difference (ΔVF_{D1-D4}) comprises applying the following rules:
- if the first voltage difference (ΔVF_{D2-D3}) is higher than the first predetermined threshold voltage value (Vth') or the second voltage difference (ΔVF_{D4-D1}) is higher than the second predetermined threshold voltage value (Vth"), a short circuit is detected;
- if the first voltage difference (ΔVF_{D2-D3}) is greater than the second voltage difference (ΔVF_{D4-D1}), there is a short circuit between the first phase (18a') and a ground (G) of the supply circuit (1);
- if the first voltage difference (ΔVF_{D2-D3}) is lower than the second voltage difference (ΔVF_{D4-D1}), there is a short circuit between the second phase (18b') and the ground (G);
- if the first voltage difference (ΔVF_{D2-D3}) is equal to the second voltage difference (ΔVF_{D4-D1}), there is a short circuit between the first phase (18a') and the second phase (18b').

12. The method according to claim 3, wherein applying (106) a predetermined closing/opening sequence to the switches (S1-S6) comprises the steps of:
- closing the fifth switch (S5), between an initial time (t0) and a first time (t1), to detect if there is a short circuit between the third branch (18c) and the ground (G);
- opening, at the first time (t1), the fifth switch S5;
- closing the third switch (S3), between the first time (t1) and a second time (t2), to detect if there is a short circuit between the second branch (18b) and the ground (G);
- opening, at the second time (t2), the third switch S3;
- closing the first switch (S1), between the second time (t2) and a third time (t3), to detect if there is a short circuit between the first branch (18a) and the ground (G);
- closing the fourth switch (S4), between the third time (t3) and a fourth time (t4), to detect if there is a short circuit between the first branch (18a) and the second branch (18b);
- opening, at the fourth time (t4), the fourth switch (S4);
- closing sixth switch (S6), between the fourth time (t4) and a fifth time (t5), to detect if there is a short circuit between the first branch (18a) and the third branch (18c);
- opening, at the fifth time (t5), the first switch (S1);
- closing the third switch (S3), between the fifth time (t5) and a sixth time (t6), to detect if there is a short circuit between the second branch (18b) and the third branch (18c);
- opening, at the sixth time (t6), both the third switch (S3) and the sixth switch (S6).

13. The method of claim 1, wherein when a short circuit occurs in the supply circuit (1) of the PMM motor (2), an alert is sent to a control unit of a train wherein the PMM motor (2) is hosted.

## Amended claims

### Amended claims in accordance with Rule 137(2) EPC.

1. Method for localizing short circuits in a supply circuit (1) of a PMM motor (2), said supply circuit (1) comprising:
- a DC voltage source (4) placed between a first branch (4a) and a second branch (4b);
- parallel branches (10b, 10c, 10d, 10e) placed in parallel between the positive branch (4a) and the negative branch (4b) wherein:
- on a first parallel branch (10b) there is a capacitor (14);
- on second (10c), third(10d) and fourth (10e) parallel branches there are respective couple of switches placed in series, in particular a first switch (S1) and a second switch (S2) on the second parallel branch (10c), a third switch (S3) and a fourth switch (S4) on the third parallel branch (10d), a fifth switch (S5) and a sixth switch (S6) on the fourth parallel branch (10e);
- three branches (18a, 18b, 18c) connecting on one side respective phases (18a', 18b', 18c') of the PMM motor (2) with, on the opposite side, the second, third and fourth parallel branches (10c, 10d, 10e), between the respective couples of switches (S1, S2; S3, S4; S5, S6);
- a voltage sensor (12) adapted for measuring the voltage on the capacitor (14);
the method comprising the steps of:
a) charging (100) the capacitor (14) at a predetermined initial voltage value (V0) through the DC voltage source (4);
b) opening a first switch (6) placed on the first branch (4a) so as to isolate the capacitor (14) from the DC voltage source (4) and leaving the capacitor (14) fully charged;
c) transferring (200) energy from the capacitor (14) to the PMM motor (2) through the first switch (S1) and the fourth switch (S4) in a first period and returning (202) energy to the capacitor (14) through freewheeling diodes (D2, D3) respectively associated to the second switch (S2) and to the third switch (S3) in a following second period;
d) measuring (204) a first voltage difference (ΔVF_{D2-D3}) between said predetermined initial voltage value (V0) and a first final voltage value (Vth1) on the capacitor (14) at the end of the second period;
e) detecting a short circuit in function of the comparison of the first voltage difference (ΔVF_{D2-D3}) with a first predetermined threshold voltage value (Vth');
f) applying (106) a predetermined closing/opening sequence to the switches (S1-S6);
g) checking (108), through the voltage sensor (12), if a short circuit voltage drop has occurred on the capacitor (14) and in positive case, localizing (110) the short circuit by correlating the closing/opening sequence of the switches (S1-S6) with said short circuit voltage drop.

2. The method of claim 1, further comprising:
h) repeating steps c) and d) by closing the third switch (S3) and the second switch (S2) in a third period and transferring the energy back through freewheeling diodes (D1, D4) respectively associated to the first switch (S1) and to the fourth switch (S4) in a following fourth period, thus obtaining a second voltage difference (Δ_{VFD1-D4}) between the predetermined initial voltage value (V0) and a second final voltage value (Vth2) at the end of the fourth period;
i) detecting a short circuit in function of the comparison of the second voltage difference (Δ_{VFD1-D4}) with a second predetermined threshold voltage value (Vth").

3. The method according to any of the preceding claims, wherein a three-phase switch (18), is placed on the three branches (18a, 18b, 18c).

4. The method according to any of the preceding claims, wherein the parallel branches comprise a fifth parallel branch (10a) comprising a voltage sensor (12).

5. The method of claim 2, further comprising:
- j) in case a short circuit is detected in step e) or i), localizing the short circuit by comparing the values of the first voltage difference (ΔVF_{D2-D3}) and second voltage difference (ΔVF_{D1-D4});

6. The method of claim 2, further comprising:
in case the short circuit is not detected in e) or i), repeating the steps c) and d) for the second phase (18b') and the third phase (18c') and for the third phase (18c') and the first phase (18a') using the corresponding switches (S3, S6; S4, S5).

7. The method of claim 1, further comprising:
- if the capacitor (14) does not charge, localize a short circuit bypassing the capacitor (14)

8. The method according to claim 1, wherein the step of transferring (200) energy from the capacitor (14) to the PMM motor (2) includes the steps of:
- transferring (200) energy from the capacitor (14) to the first phase (18a') of the PMM motor (2) and then to the second phase (18b') by means of a current flowing through the first switch (S1) and the fourth switch (S4);
- transferring back (202) energy from the PMM motor (2) to the capacitor (14) by means of a current flowing through the freewheeling diodes (D2, D3) respectively associated to the second switch (S2) and to the third switch (S3);

9. The method according to claim 2, wherein the step of repeating steps c) and d) by closing the third switch (S3) and the second switch (S2) includes the steps of:
- charging (206) again the capacitor (14) to the predetermined initial voltage value (V0);
- repeating steps c) and d) by transferring (200) energy from the capacitor (14) to the second phase (18b') of the PMM motor (2) and then to the first phase (18a') by means of a current flowing through the third switch (S3) and the second switch (S2) closing the third switch (S3) and the second switch (S2) and by transferring the energy back from the PMM motor (2) to the capacitor (14) through the freewheeling diodes (D1, D4) respectively associated to the first switch (S1) and to the fourth switch (S4).

10. The method according to claim 5, wherein the step of localizing the short circuit by comparing the values of the first voltage difference (ΔVF_{D2-D3}) and second voltage difference (ΔVF_{D1-D4}) comprises applying the following rules:
- if the first voltage difference (ΔVF_{D2-D3}) is higher than the first predetermined threshold voltage value (Vth') or the second voltage difference (ΔVF_{D4-D1}) is higher than the second predetermined threshold voltage value (Vth"), a short circuit is detected;
- if the first voltage difference (ΔVF_{D2-D3}) is greater than the second voltage difference (ΔVF_{D4-D1}), there is a short circuit between the first phase (18a') and a ground (G) of the supply circuit (1);
- if the first voltage difference (ΔVF_{D2-D3}) is lower than the second voltage difference (ΔVF_{D4-D1}), there is a short circuit between the second phase (18b') and the ground (G);
- if the first voltage difference (ΔVF_{D2-D3}) is equal to the second voltage difference (ΔVF_{D4-D1}), there is a short circuit between the first phase (18a') and the second phase (18b').

11. The method according to claim 1, wherein applying (106) a predetermined closing/opening sequence to the switches (S1-S6) comprises the steps of:
- closing the fifth switch (S5), between an initial time (t0) and a first time (t1), to detect if there is a short circuit between the third branch (18c) and the ground (G);
- opening, at the first time (t1), the fifth switch S5;
- closing the third switch (S3), between the first time (t1) and a second time (t2), to detect if there is a short circuit between the second branch (18b) and the ground (G);
- opening, at the second time (t2), the third switch S3;
- closing the first switch (S1), between the second time (t2) and a third time (t3), to detect if there is a short circuit between the first branch (18a) and the ground (G);
- closing the fourth switch (S4), between the third time (t3) and a fourth time (t4), to detect if there is a short circuit between the first branch (18a) and the second branch (18b);
- opening, at the fourth time (t4), the fourth switch (S4);
- closing sixth switch (S6), between the fourth time (t4) and a fifth time (t5), to detect if there is a short circuit between the first branch (18a) and the third branch (18c);
- opening, at the fifth time (t5), the first switch (S1);
- closing the third switch (S3), between the fifth time (t5) and a sixth time (t6), to detect if there is a short circuit between the second branch (18b) and the third branch (18c);
- opening, at the sixth time (t6), both the third switch (S3) and the sixth switch (S6).

12. The method of claim 1, wherein when a short circuit occurs in the supply circuit (1) of the PMM motor (2), an alert is sent to a control unit of a train wherein the PMM motor (2) is hosted.
